# EUROPEAN PATENT APPLICATION

(11) **EP 4 187 168 A1**
(43) Date of publication of application: **31.05.2023**
(21) Application number: 22209250.4
(22) Date of filing: 24.11.2022
(51) Int. Cl.: F24F 11/77

(54) **CONTROL METHOD FOR VEHICLE-MOUNTED WIRELESS CHARGER, VEHICLE-MOUNTED WIRELESS CHARGER AND VEHICLE**

(30) Priority: 29.11.2021 CN 202111437470
(71) Applicant: Nio Technology (Anhui) Co., Ltd, Hefei City, Anhui 230601 (CN)
(72) Inventor: LU, Qian, Shanghai 201805 (CN); SUN, Chenwei, Shanghai 201805 (CN); SHI, Xiaolei, Shanghai 201805 (CN); MU, Lin, Shanghai 201805 (CN)
(74) Representative: Vossius & Partner Patentanwälte Rechtsanwälte mbB

(57) **Abstract**

The disclosure relates to a control method for a vehicle-mounted wireless charger, a vehicle-mounted wireless charger, and a vehicle. The vehicle-mounted wireless charger has a fan, and the control method includes: establishing a functional relationship between a vehicle speed of a vehicle and a duty cycle of the fan; detecting a real-time vehicle speed of the vehicle when the wireless charger charges a device to be charged and the fan is turned on; and determining and adjusting the duty cycle of the fan based on the real-time vehicle speed and the functional relationship, to control noise of the vehicle-mounted wireless charger. The vehicle of the disclosure may effectively control the noise of the vehicle-mounted wireless charger using the control method, thereby improving the NVH performance of the vehicle and driving experience of a user.

## Description

### Technical Field

The disclosure relates to the field of vehicle technologies, and in particular, to a control method for a vehicle-mounted wireless charger, a vehicle-mounted wireless charger, and a vehicle.

### Background Art

As novel electronic products (such as smartphones, wireless headsets, and tablet computers) rapidly advance, matching charging devices have constantly emerged. Currently, most common charging devices are wired chargers. The wired chargers transmit currents through wires, which belongs to contact transmission. In practice, the wired chargers have many problems: 1. different wired chargers have poor compatibility and versatility with one another; 2. the wireless chargers are prone to entanglement, causing inconvenience for users to use and carry; 3. frequent plugging easily causes damage to the chargers and devices to be charged, and may cause problems such as contact sparks, explosion and electric shocks, etc.

With the continuous development of wireless charging technologies, wireless chargers have emerged. The wireless chargers are devices that perform charging by utilizing the electromagnetic induction principle. The principle is as follows: a coil is placed at each of a sending end and a receiving end, the coil at the sending end sends an electromagnetic signal under the action of electric power, and the coil at the receiving end receives and converts the electromagnetic signal into a current, thereby realizing the purpose of wireless charging. There are mainly three transmission modes for the wireless charging: electromagnetic induction, electromagnetic resonance, and electromagnetic radiation. Due to that the non-contact charging mode is used, the wireless chargers may better solve the problems of the wired chargers. The wireless chargers have advantages such as convenience, reliability, handiness, safety, etc., thus being favored by more users.

In order to realize fast charging of a device to be charged, the high-power technology has been applied to the wireless chargers, which results in a fast temperature rise of the wireless chargers when the wireless chargers are in use. Accordingly, a wireless charging apparatus with a cooling fan has been developed in the prior art, to solve this problem. For example, Chinese Utility Model Patent CN 21381729 U discloses a wireless charging apparatus, which includes at least one cooling fan. When a temperature sensor senses that an operating temperature is higher than or equal to a start-up temperature of the fan, a microcontroller controls the at least one cooling fan to operate, and a rotational speed of the at least one cooling fan increases as the operating temperature increases. The at least one cooling fan is controlled, which may prevent heat accumulation of the wireless charging apparatus and/or a mobile apparatus (namely the device to be charged) in the fast-charging process.

A vehicle-mounted wireless charger is a wireless charger mounted on a vehicle. The operating of a fan of the vehicle-mounted wireless charger plays the role of heat dissipation, but increases noise in the vehicle at the same, which impairs the noise, vibration and harshness (NVH) performance of the vehicle, thereby reducing the user experience. Compared with conventional fuel vehicles, new energy vehicles (such as battery electric vehicles, etc.) have better overall NVH performance, and the noise of the vehicle-mounted wireless charger has a particularly obvious impact on them.

Accordingly, a novel technical solution is required in the art, to solve the problems described above.

### Summary of the Disclosure

To solve the above problems in the prior art, that is, to solve the technical problems in the prior art that noise of a vehicle-mounted wireless charger cannot be effectively controlled, the disclosure provides a control method for a vehicle-mounted wireless charger. The vehicle-mounted wireless charger has a fan, and the control method includes:
establishing a functional relationship between a vehicle speed of a vehicle and a duty cycle of the fan;
detecting a real-time vehicle speed of the vehicle when the wireless charger charges a device to be charged and the fan is turned on; and
determining and adjusting the duty cycle of the fan based on the real-time vehicle speed and the functional relationship, to control noise of the vehicle-mounted wireless charger.

In the control method for a vehicle-mounted wireless charger according to the disclosure, the functional relationship between the vehicle speed of the vehicle and the duty cycle of the fan is first established. It may be understood that the vehicle speed of the vehicle is one of the most important variables affecting vehicle noise. The higher the vehicle speed, the larger the vehicle noise. In addition, a rotational speed of the fan is also one of the most important variables affecting noise of the vehicle-mounted wireless charger. The higher the rotational speed of the fan, the larger the noise of the vehicle-mounted wireless charger. Establishing the functional relationship between the vehicle speed of the vehicle and the duty cycle of the fan may control the duty cycle of the fan in a targeted manner, thereby improving the control precision. When the vehicle-mounted wireless charger charges the device to be charged and the fan is turned on, the real-time vehicle speed of the vehicle is detected. Then, the duty cycle of the fan is determined and adjusted based on the real-time vehicle speed and the functional relationship between the vehicle speed and the duty cycle of the fan, to control the noise of the vehicle-mounted wireless charger. According to the control method of the disclosure, through the above settings, the duty cycle of the fan may be determined and adjusted based on different vehicle speeds of the vehicle, so as to control the noise of the vehicle-mounted wireless charger, which prevents the noise of the vehicle-mounted wireless charger from being too large and consequently affecting the NVH performance of the vehicle, thereby ensuring the driving experience of a user.

In a preferred technical solution of the above control method for a vehicle-mounted wireless charger, the step of "determining and adjusting the duty cycle of the fan based on the real-time vehicle speed and the functional relationship" includes:
determining a theoretical duty cycle of the fan based on the real-time vehicle speed and the functional relationship; and
controlling the fan to operate at the theoretical duty cycle. After the theoretical duty cycle of the fan is determined based on the real-time vehicle speed of the vehicle and the functional relationship, the fan is directly controlled to operate at the theoretical duty cycle, which may simplify the control logic, thus being easy to operate.

In a preferred technical solution of the above control method for a vehicle-mounted wireless charger, the step of "determining and adjusting the duty cycle of the fan based on the real-time vehicle speed and the functional relationship" includes:
determining a theoretical duty cycle of the fan based on the real-time vehicle speed and the functional relationship;
obtaining an output power of the vehicle-mounted wireless charger;
comparing the output power with a preset power threshold; and
when the output power is greater than the preset power threshold, controlling the fan to operate at the theoretical duty cycle. After the theoretical duty cycle of the fan is determined, a new control parameter, namely the output power of the vehicle-mounted wireless charger, is introduced into the control method. It should be noted that when the vehicle-mounted wireless charger charges the device to be charged, there is a reverse change trend between the output power of the vehicle-mounted wireless charger and an electricity quantity of the device to be charged. In other words, the smaller the electricity quantity of the device to be charged, the higher the output power of the vehicle-mounted wireless charger; and the larger the electricity quantity of the device to be charged, the lower the output power of the vehicle-mounted wireless charger. Correspondingly, when the output power of the vehicle-mounted wireless charger is higher, a temperature thereof rises faster, and a requirement for the air volume is greater; and as the output power of the vehicle-mounted wireless charger is lower, the temperature thereof rises slower, and the requirement for the air volume is smaller. Therefore, introducing the output power of the vehicle-mounted wireless charger as a new parameter for adjusting the duty cycle of the fan may further improve the control precision. When the output power is greater than the preset power threshold, it indicates that the device to be charged still has a low electricity quantity and a great requirement for the air volume, and in this case, the fan is controlled to operate at the theoretical duty cycle, which may meet both the noise control requirement and the air volume requirement.

In a preferred technical solution of the above control method for a vehicle-mounted wireless charger, after the step of "determining and adjusting the duty cycle of the fan based on the real-time vehicle speed and the functional relationship", the control method further includes: detecting an actual duty cycle of the fan;
calculating a ratio of the actual duty cycle to the theoretical duty cycle;
when the ratio is within a preset ratio range, keeping the fan operating at the actual duty cycle; and
when the ratio exceeds the preset ratio range, controlling the fan to be turned off, and sending an alarm signal. Through the above settings, whether the fan operates normally may be monitored, which may prevent the actual duty cycle of the fan from being too large and consequently too much noise is produced, and may also prevent the actual duty cycle of the fan from being too small to meet a heat dissipation requirement.

In a preferred technical solution of the above control method for a vehicle-mounted wireless charger, the control method further includes: when the output power is less than or equal to the preset power threshold, determining an energy saving duty cycle of the fan, where the energy saving duty cycle is equal to the theoretical duty cycle multiplied by an energy saving coefficient, and the energy saving coefficient is greater than 0 and less than 1; and
controlling the fan to operate at the energy saving duty cycle. When the output power is less than or equal to the preset power threshold, it indicates that the electricity quantity of the device to be charged is relatively high and the requirement for the air volume is smaller, and thus the fan is controlled to operate at the energy saving duty cycle. The energy saving duty cycle is equal to the theoretical duty cycle multiplied by the energy saving coefficient, and the energy saving coefficient is greater than 0 and less than 1. Through the above settings, the duty cycle of the fan may be reduced as much as possible under the condition that the noise control and the air volume control are met, which can reduce the noise of the vehicle-mounted wireless charger, and also reduce energy consumption and save energy.

In a preferred technical solution of the above control method for a vehicle-mounted wireless charger, after the step of "determining and adjusting the duty cycle of the fan based on the real-time vehicle speed and the functional relationship", the control method further includes: detecting an actual duty cycle of the fan;
calculating a ratio of the actual duty cycle to the energy saving duty cycle;
when the ratio is within a preset ratio range, keeping the fan operating at the actual duty cycle; and
when the ratio exceeds the preset ratio range, controlling the fan to be turned off, and sending an alarm signal. Through the above settings, whether the fan operates normally may be monitored, which may prevent the actual duty cycle of the fan from being too large and consequently too much noise is produced, and may also prevent the actual duty cycle of the fan from being too small to meet a heat dissipation requirement.

In a preferred technical solution of the above control method for a vehicle-mounted wireless charger, the step of "establishing a functional relationship between a vehicle speed of a vehicle and a duty cycle of the fan" includes:
presetting a first functional relationship between the vehicle speed and the vehicle noise, a second functional relationship between the fan noise and the duty cycle of the fan, and a third functional relationship between the vehicle noise and the fan noise; and
establishing the functional relationship between the vehicle speed and the duty cycle of the fan based on the first functional relationship, the second functional relationship, and the third functional relationship. Through the above settings, the functional relationship between the vehicle speed and the duty cycle of the fan may be precisely established, thereby improving the control precision.

In a preferred technical solution of the above control method for a vehicle-mounted wireless charger, the step of presetting a first functional relationship between the vehicle speed and the vehicle noise includes:
dividing the vehicle speed into a plurality of vehicle speed intervals; and
presetting the first functional relationship between each of the vehicle speed intervals and the vehicle noise. Dividing the vehicle speed into the plurality of vehicle speed intervals and presetting the first functional relationship between each of the vehicle speed intervals and the vehicle noise, rather than presetting the first functional relationship between each vehicle speed and the vehicle noise may simplify the control procedure and reduce the control cost.

In a preferred technical solution of the above control method for a vehicle-mounted wireless charger, the plurality of vehicle speed intervals includes:
a first vehicle speed interval, the first vehicle speed interval referring to a range of 30 km/h or less, and the functional relationship between the vehicle speed and the duty cycle of the fan being that the duty cycle of the fan is 42% when the vehicle speed is within the first vehicle speed interval;
a second vehicle speed interval, the second vehicle speed interval being between 30 km/h (not including 30 km/h) and 60 km/h, and the functional relationship between the vehicle speed and the duty cycle of the fan being that the duty cycle of the fan is 48% when the vehicle speed is within the second vehicle speed interval;
a third vehicle speed interval, the third vehicle speed interval being between 60 km/h (not including 60 km/h) and 80 km/h, and the functional relationship between the vehicle speed and the duty cycle of the fan being that the duty cycle of the fan is 56% when the vehicle speed is within the third vehicle speed interval; and
a fourth vehicle speed interval, the fourth vehicle speed interval referring to a range of 80 km/h or more, and the functional relationship between the vehicle speed and the duty cycle of the fan being that the duty cycle of the fan is 60% when the vehicle speed is within the fourth vehicle speed interval. The functional relationship between the vehicle speed and the duty cycle of the fan is determined based on each of the vehicle speed intervals, which may simplify the functional relationship, and improve the control precision of the vehicle-mounted wireless charger.

In a preferred technical solution of the above control method for a vehicle-mounted wireless charger, the control method further includes: detecting a temperature of the vehicle-mounted wireless charger after the vehicle-mounted wireless charger charges the device to be charged;
comparing the temperature with a preset temperature threshold; and
when the temperature is greater than the preset temperature threshold, controlling the fan to be turned on at an initial duty cycle. Through the above settings, a time for turning on the fan may be more reasonable, which avoids an increase in the noise of the vehicle-mounted wireless charger due to that the fan is turned on too early.

To solve the above problems in the prior art, that is, to solve the technical problems in the prior art that noise of a vehicle-mounted wireless charger cannot be effectively controlled, the disclosure further provides a vehicle-mounted wireless charger. The vehicle-mounted wireless charger uses the control method for a vehicle-mounted wireless charger according to any one of the above. The vehicle-mounted wireless charger of the disclosure may effectively control the duty cycle of the fan using the control method for a vehicle-mounted wireless charger according to any one of the above, thereby avoiding excessive noise of the vehicle-mounted wireless charger.

To solve the above problems in the prior art, that is, to solve the technical problems in the prior art that noise of a vehicle-mounted wireless charger cannot be effectively controlled, the disclosure further provides a vehicle. The vehicle includes the above vehicle-mounted wireless charger. The vehicle of the disclosure may effectively control the noise of the vehicle-mounted wireless charger using the above vehicle-mounted wireless charger, thereby improving the NVH performance of the vehicle and driving experience of a user.

### Solution 1:

1. A control method for a vehicle-mounted wireless charger, where the vehicle-mounted wireless charger has a fan, and the control method includes:
   establishing a functional relationship between a vehicle speed of a vehicle and a duty cycle of the fan;
   detecting a real-time vehicle speed of the vehicle when the vehicle-mounted wireless charger charges a device to be charged and the fan is turned on; and
   determining and adjusting the duty cycle of the fan based on the real-time vehicle speed and the functional relationship, to control noise of the vehicle-mounted wireless charger.

### Solution 2:

2. The control method for a vehicle-mounted wireless charger according to solution 1, where the step of "determining and adjusting the duty cycle of the fan based on the real-time vehicle speed and the functional relationship" includes:
determining a theoretical duty cycle of the fan based on the real-time vehicle speed and the functional relationship;
controlling the fan to operate at the theoretical duty cycle.

### Solution 3:

3. The control method for a vehicle-mounted wireless charger according to solution 1, where the step of "determining and adjusting the duty cycle of the fan based on the real-time vehicle speed and the functional relationship" includes:
determining a theoretical duty cycle of the fan based on the real-time vehicle speed and the functional relationship;
obtaining an output power of the vehicle-mounted wireless charger;
comparing the output power with a preset power threshold; and
when the output power is greater than the preset power threshold, controlling the fan to operate at the theoretical duty cycle.

### Solution 4:

4. The control method for a vehicle-mounted wireless charger according to solution 2 or 3, where after the step of "determining and adjusting the duty cycle of the fan based on the real-time vehicle speed and the functional relationship", the control method further includes: detecting an actual duty cycle of the fan;
calculating a ratio of the actual duty cycle to the theoretical duty cycle;
when the ratio is within a preset ratio range, keeping the fan operating at the actual duty cycle; and
when the ratio exceeds the preset ratio range, controlling the fan to be turned off, and sending an alarm signal.

### Solution 5:

5. The control method for a vehicle-mounted wireless charger according to solution 3, where
determining an energy saving duty cycle of the fan when the output power is less than or equal to the preset power threshold, where the energy saving duty cycle is equal to the theoretical duty cycle multiplied by an energy saving coefficient, and the energy saving coefficient is greater than 0 and less than 1; and
controlling the fan to operate at the energy saving duty cycle.

### Solution 6:

6. The control method for a vehicle-mounted wireless charger according to solution 5, where after the step of "determining and adjusting the duty cycle of the fan based on the real-time vehicle speed and the functional relationship", the control method further includes: detecting an actual duty cycle of the fan;
calculating a ratio of the actual duty cycle to the energy saving duty cycle;
when the ratio is within a preset ratio range, keeping the fan operating at the actual duty cycle; and
when the ratio exceeds the preset ratio range, controlling the fan to be turned off, and sending an alarm signal.

### Solution 7:

7. The control method for a vehicle-mounted wireless charger according to solution 1, where the step of "establishing a functional relationship between a vehicle speed of a vehicle and a duty cycle of the fan" includes:
presetting a first functional relationship between the vehicle speed and the vehicle noise, a second functional relationship between the fan noise and the duty cycle of the fan, and a third functional relationship between the vehicle noise and the fan noise; and
establishing the functional relationship between the vehicle speed and the duty cycle of the fan based on the first functional relationship, the second functional relationship, and the third functional relationship.

### Solution 8:

8. The control method for a vehicle-mounted wireless charger according to solution 7, where the step of presetting a first functional relationship between the vehicle speed and the vehicle noise includes:
dividing the vehicle speed into a plurality of vehicle speed intervals; and
presetting the first functional relationship between each of the vehicle speed intervals and the vehicle noise.

### Solution 9:

9. The control method for a vehicle-mounted wireless charger according to solution 8, where the plurality of vehicle speed intervals includes:
a first vehicle speed interval, the first vehicle speed interval referring to a range of 30 km/h or less, and the functional relationship between the vehicle speed and the duty cycle of the fan being that the duty cycle of the fan is 42% when the vehicle speed is within the first vehicle speed interval;
a second vehicle speed interval, the second vehicle speed interval being between 30 km/h (not including 30 km/h) and 60 km/h, and the functional relationship between the vehicle speed and the duty cycle of the fan being that the duty cycle of the fan is 48% when the vehicle speed is within the second vehicle speed interval;
a third vehicle speed interval, the third vehicle speed interval being between 60 km/h (not including 60 km/h) and 80 km/h, and the functional relationship between the vehicle speed and the duty cycle of the fan being that the duty cycle of the fan is 56% when the vehicle speed is within the third vehicle speed interval; and
a fourth vehicle speed interval, the fourth vehicle speed interval referring to a range of 80 km/h or more, and the functional relationship between the vehicle speed and the duty cycle of the fan being that the duty cycle of the fan is 60% when the vehicle speed is within the fourth vehicle speed interval.

### Solution 10:

10. The control method for a vehicle-mounted wireless charger according to solution 1, where detecting a temperature of the vehicle-mounted wireless charger after the vehicle-mounted wireless charger charges the device to be charged;
comparing the temperature with a preset temperature threshold; and
when the temperature is greater than the preset temperature threshold, controlling the fan to be turned on at an initial duty cycle.

### Solution 11:

11. A vehicle-mounted wireless charger, where the vehicle-mounted wireless charger uses the control method for a vehicle-mounted wireless charger according to any one of solutions 1 to 10.

### Solution 12:

12. A vehicle, where the vehicle includes the vehicle-mounted wireless charger according to solution 11.

### Brief Description of the Drawings

Preferred implementations of the disclosure are described below with reference to drawings. Among the drawings:
FIG. 1 is a schematic flowchart of a control method for a vehicle-mounted wireless charger according to the disclosure;
FIG. 2 is a schematic flowchart of a first embodiment of a control method for a vehicle-mounted wireless charger according to the disclosure;
FIG. 3 is a schematic flowchart of a second embodiment of a control method for a vehicle-mounted wireless charger according to the disclosure; and
FIG. 4 is a schematic flowchart of a third embodiment of a control method for a vehicle-mounted wireless charger according to the disclosure.

### Detailed Description of Embodiments

Preferred embodiments of the disclosure are described below with reference to the accompanying drawings. Those skilled in the art should understand that these implementations are only used to explain the technical principles of the disclosure, and are not intended to limit the scope of protection of the disclosure.

To solve the technical problems in the prior art that noise of a vehicle-mounted wireless charger cannot be effectively controlled, the disclosure provides a control method for a vehicle-mounted wireless charger. The vehicle-mounted wireless charger has a fan, and the control method includes:
establishing a functional relationship between a vehicle speed of a vehicle and a duty cycle of the fan (step S 1);
detecting a real-time vehicle speed of the vehicle when the vehicle-mounted wireless charger charges a device to be charged and the fan is turned on (step S2);
determining and adjusting the duty cycle of the fan based on the real-time vehicle speed and the functional relationship, to control noise of the vehicle-mounted wireless charger (step S3).

Herein, the term "duty cycle" refers to a ratio of an energizing time to a total time within a pulse cycle, unless expressly stated to the contrary.

In one or more embodiments, the vehicle of the disclosure is a battery electric vehicle. Alternatively, the vehicle may be a hybrid vehicle, a fuel vehicle, or another proper vehicle. The vehicle includes but is not limited to components such as a vehicle body, a vehicle door, a battery, and the vehicle-mounted wireless charger. In one or more embodiments, the vehicle-mounted wireless charger is configured to be fixed on the vehicle. Alternatively, the vehicle-mounted wireless charger may be provided separately, and configured to be electrically connected to the battery of the vehicle, so as to charge a device to be charged (e.g., a mobile phone, a headset, a tablet computer, etc.) having a wireless charging function.

In one or more embodiments, the vehicle-mounted wireless charger of the disclosure includes but is not limited to components such as a housing, a generating end coil, a fan, a temperature sensor, and a microcontroller. The housing may be made of any proper material such as aluminum alloy, etc., which makes it have good insulation and mechanical strength. In one or more embodiments, there are a plurality of air outlets on each of both sides of the housing for heat dissipation. The generating end coil is arranged inside the housing. In one or more embodiments, the generating end coil is made by winding an enameled wire, a cotton covered wire, or another proper inductive coil. The fan is arranged at a lower part of the coil or another proper position. In one or more embodiments, the fan is a centrifugal fan. The centrifugal fan is made of polyphenylene sulfide (PPS), phenol-formaldehyde resin or another proper resin material, so as to reduce a weight of the fan, thereby reducing the noise produced during rotation of the fan. In one or more embodiments, the fan is configured in a manner that a duty cycle of the fan may be controlled by the microprocessor and based on pulse-width modulation (PWM), so as to control a rotational speed of the fan. A square wave with a specific frequency in the PWM is constituted by a high level and a low level. Assuming that a duration of the high level is T1 and a duration of the low level is T2, a period T = T 1 + T2. The duty cycle of the fan may be adjusted by controlling the duration T 1 of the high level, thereby controlling the rotational speed of the fan. The temperature sensor is arranged near the generating end coil, to detect a temperature of the vehicle-mounted wireless charger. In one or more embodiments, the temperature sensor is a negative temperature coefficient (NTC) thermistor, which improves the temperature detection precision. In addition, the vehicle-mounted wireless charger is configured to transmit a sensing signal. When the device to be charged having the wireless charging function is placed on or near the vehicle-mounted wireless charger, the vehicle-mounted wireless charger may receive a corresponding sensing signal, to determine whether there is a proper device to be charged that needs charging.

The control method for a vehicle-mounted wireless charger according to the disclosure is described in detail below with reference to the embodiments of the above vehicle and vehicle-mounted wireless charger according to the disclosure.

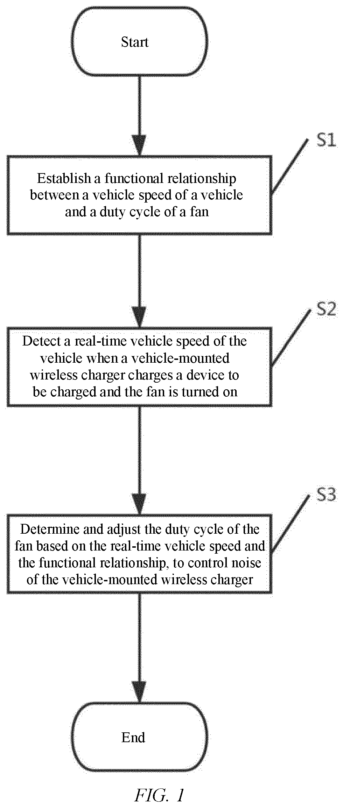

FIG. 1 is a schematic flowchart of a control method for a vehicle-mounted wireless charger according to the disclosure. As shown in FIG. 1, in one or more embodiments, after the control method for a vehicle-mounted wireless charger according to the disclosure is started, step S 1 is first performed, that is, a functional relationship between a vehicle speed of a vehicle and a duty cycle of a fan is established. When the vehicle-mounted wireless charger charges a device to be charged and the fan is turned on, step S2 is performed, that is, a real-time vehicle speed of the vehicle is detected. Then, the duty cycle of the fan is determined and adjusted based on the real-time vehicle speed and the functional relationship, to control noise of the vehicle-mounted wireless charger (step S3).

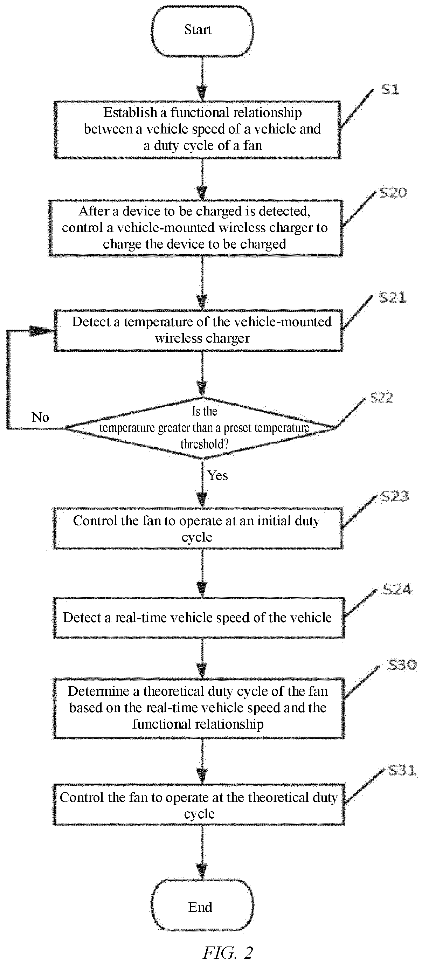

FIG. 2 is a schematic flowchart of a first embodiment of a control method for a vehicle-mounted wireless charger according to the disclosure. As shown in FIG. 2, in one or more embodiments, after the control method for a vehicle-mounted wireless charger according to the disclosure is started, step S1 is first performed, that is, a functional relationship between a vehicle speed of a vehicle and a duty cycle of a fan is established. In one or more embodiments, the step of "establishing a functional relationship between a vehicle speed of a vehicle and a duty cycle of a fan" includes: (1) presetting a first functional relationship between the vehicle speed and vehicle noise; (2) presetting a second functional relationship between fan noise and the duty cycle of the fan; (3) presetting a third functional relationship between the vehicle noise and the fan noise; and (4) establishing the functional relationship between the vehicle speed and the duty cycle of the fan based on the first functional relationship, the second functional relationship, and the third functional relationship. In one or more embodiments, the first functional relationship is obtained by detecting the vehicle noise of the vehicle at different vehicle speeds and using a mathematical model. The mathematical model is that each vehicle speed corresponds to a vehicle noise value. The establishment of such a mathematical model may improve the control precision. Alternatively, the first functional relationship may divide the vehicle speed into a plurality of vehicle speed intervals, and then the first functional relationship between each of the vehicle speed intervals and the vehicle noise is preset. For example, each vehicle speed interval corresponds to a vehicle noise value, which simplifies the control logic and reduces the control cost. In one or more embodiments, the second functional relationship is obtained by detecting the fan noise of the fan at different duty cycles and using a corresponding mathematical model. Herein, the mathematical model is that each duty cycle of the fan corresponds to a fan noise value. In one or more embodiments, the third functional relationship is that the vehicle noise equals to the fan noise. Setting the vehicle noise to be equal to the fan noise may not only simplify the control logic but also may use the vehicle noise (namely the fan noise) at different vehicle speeds as a basis for adjusting the duty cycle of the fan, which may ensure that the noise of the vehicle-mounted wireless charger is not significantly greater than the vehicle noise, thereby reducing perception by a user of the noise of the vehicle-mounted wireless charger, and improving the driving experience of the user. In one or more embodiments, the vehicle speed of the vehicle is divided into four vehicle speed intervals, and the corresponding functional relationship between the vehicle speed and the duty cycle of the fan within each vehicle speed interval is as follows: (1) a first vehicle speed interval refers to a range of 30 kilometers per hour (km/h) or less, and the functional relationship between the vehicle speed and the duty cycle of the fan is that the duty cycle of the fan is a fixed value of 42% when the vehicle speed is within the first vehicle speed interval; (2) a second vehicle speed interval being between 30 km/h (not including 30 km/h) and 60 km/h, and the functional relationship between the vehicle speed and the duty cycle of the fan is that the duty cycle of the fan is a fixed value of 48% when the vehicle speed is within the second vehicle speed interval; (3) a third vehicle speed interval being between 60 km/h (not including 60 km/h) and 80 km/h, and the functional relationship between the vehicle speed and the duty cycle of the fan is that the duty cycle of the fan is a fixed value of 56% when the vehicle speed is within the third vehicle speed interval; and (4) a fourth vehicle speed interval refers to a range of 80 km/h or more, and the functional relationship between the vehicle speed and the duty cycle of the fan is that the duty cycle of the fan is a fixed value of 60% when the vehicle speed is within the fourth vehicle speed interval. Alternatively, the functional relationship between the vehicle speed of the vehicle and the duty cycle of the fan may be another proper functional relationship. It may be understood that step S 1 may be preset in the microcontroller of the vehicle-mounted wireless charger. In addition, in one or more embodiments, a plurality of different functional relationships between the vehicle speed and the duty cycle of the fan may be preset in the microcontroller of the vehicle-mounted wireless charger, which allows a user to select the functional relationship according to actual requirements, thereby providing the user with personalized and differentiated product experience.

Still referring to FIG. 2, after step S 1 is completed, the control method proceeds to step S20, that is, after a device to be charged is detected, the vehicle-mounted wireless charger is controlled to charge the device to be charged. Next, step S21 is performed, that is, a temperature of the vehicle-mounted wireless charger is detected. Then, the detected temperature is compared with a preset temperature threshold (step S22). In one or more embodiments, the preset temperature threshold is 10°C. Alternatively, the preset temperature threshold may be set to another proper temperature higher or lower than 10°C. When a determining result is no, it indicates that the temperature of the vehicle-mounted wireless charger is still low, and there is no need to turn on the fan, which may reduce energy consumption and save energy, and may also minimize the noise of the vehicle-mounted wireless charger. Therefore, step S21 of the control method is performed again, that is, the temperature of the vehicle-mounted wireless charger continues to be detected. When the determining result is yes, it indicates that the temperature of the vehicle-mounted wireless charger is relatively high, and the fan is controlled accordingly to operate at an initial duty cycle (step S23). In one or more embodiments, the initial duty cycle is 35%. Alternatively, the initial duty cycle may be set to another proper value greater than or less than 35%. After step S23 is completed, the control method proceeds to step S24, that is, a real-time vehicle speed of the vehicle is detected. In one or more embodiments, the microcontroller of the vehicle-mounted wireless charger establishes a communication connection with a control system of the vehicle, so that the microcontroller of the vehicle-mounted wireless charger may directly read the real-time vehicle speed of the vehicle in the control system of the vehicle, thereby reducing the control cost. Next, a theoretical duty cycle of the fan is determined based on the real-time vehicle speed and the functional relationship (step S30). After step S30 is completed, step S31 is performed, that is, the fan is controlled to operate at the theoretical duty cycle. The fan is controlled to operate at the theoretical duty cycle so that the requirements for noise control and heat dissipation control may be taken into consideration, thereby making the control logic more reasonable. After step S31 is completed, the control method ends.

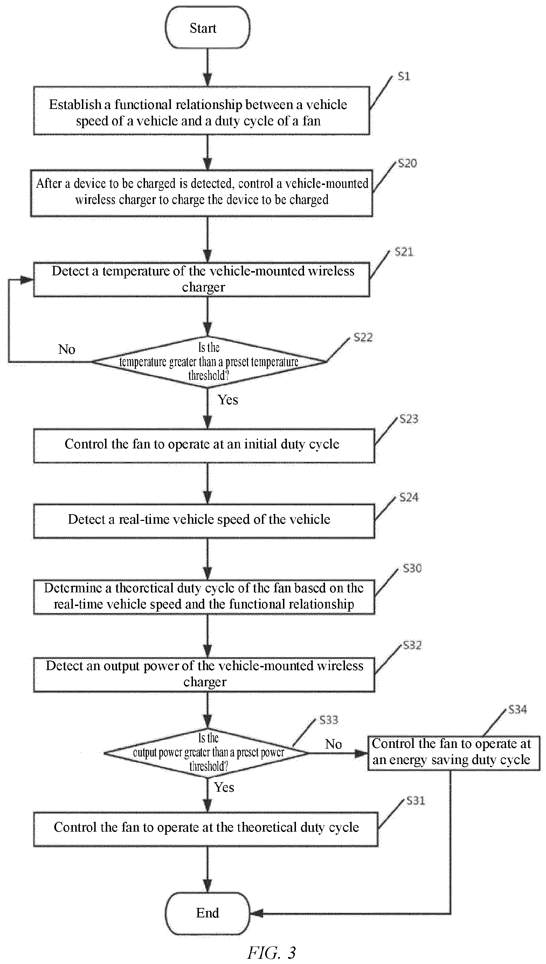

FIG. 3 is a schematic flowchart of a second embodiment of a control method for a vehicle-mounted wireless charger according to the disclosure. As shown in FIG. 3, in one or more embodiments, after the control method for a vehicle-mounted wireless charger according to the disclosure is started, step S1 is first performed, that is, a functional relationship between a vehicle speed of a vehicle and a duty cycle of a fan is established. Next, step S20 is performed, that is, after a device to be charged is detected, the vehicle-mounted wireless charger is controlled to charge the device to be charged. Then, a temperature of the vehicle-mounted wireless charger is detected (step S21). After step S21 is completed, the detected temperature is compared with a preset temperature threshold (step S22). When a determining result is no, step S21 is performed again; and when the determining result is yes, the fan is controlled to operate at an initial duty cycle (step S23). After step S23 is completed, the control method proceeds to step S24, that is, a real-time vehicle speed of the vehicle is detected. Next, a theoretical duty cycle of the fan is determined based on the real-time vehicle speed and the functional relationship (step S30).

Still referring to FIG.3, after the theoretical duty cycle of the fan is determined, the control method proceeds to step S32, that is, an output power of the vehicle-mounted wireless charger is detected. Next, whether the output power is greater than a preset power threshold is determined (step S33). In one or more embodiments, the preset power threshold is 15 watts (W). Alternatively, the preset power threshold may be another proper power value greater than or less than 15 W. When a determining result is yes, it indicates that an electricity quantity of the device to be charged is still relatively low at this time, the output power of the vehicle-mounted wireless charger is relatively large, and the requirement of the fan for the air volume is relatively great. Then, step S31 is performed, that is, the fan is controlled to operate at the theoretical duty cycle. After step S31 is completed, the control method ends. When the determining result is no, it indicates that the electricity quantity of the device to be charged is relatively high at this time, the output power of the wireless charger of the vehicle is relatively small, and the requirement of the fan for the air volume is relatively small. Then, step S34 is performed, that is, the fan is controlled to operate at an energy saving duty cycle. The energy saving duty cycle is equal to the theoretical duty cycle multiplied by an energy saving coefficient, and the energy saving coefficient is greater than 0 and less than 1. In one or more embodiments, the energy saving coefficient is 0.85. Alternatively, the energy saving coefficient may be set to another proper value greater than or less than 0.85. After step S34 is completed, the control method ends. It should be noted that parts not mentioned in the second embodiment may be the same as those in the first embodiment, and will not be described in detail herein.

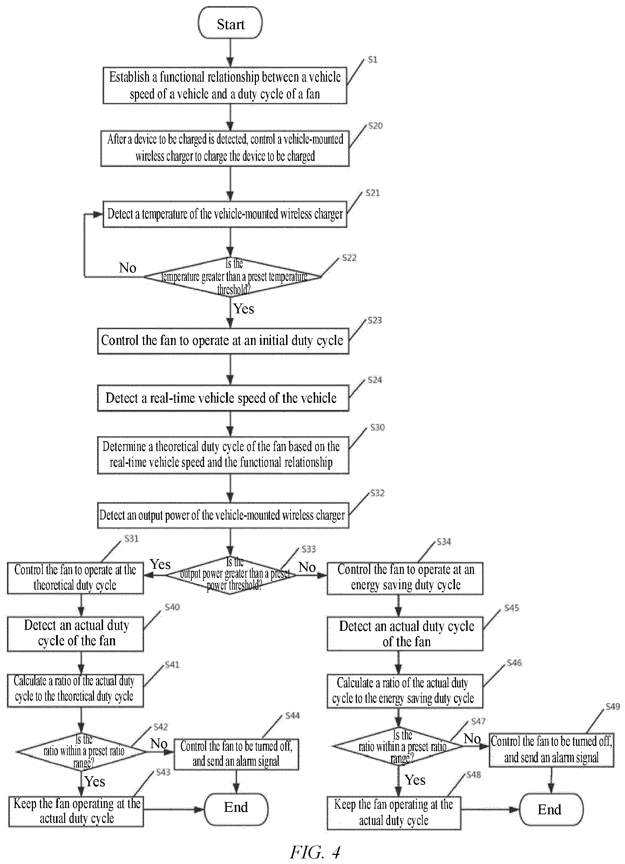

FIG. 4 is a schematic flowchart of a third embodiment of a control method for a vehicle-mounted wireless charger according to the disclosure. As shown in FIG. 4, in one or more embodiments, in one or more embodiments, after the control method for a vehicle-mounted wireless charger of the disclosure is started, step S1 is first performed, that is, a functional relationship between a vehicle speed of a vehicle and a duty cycle of a fan is established. Next, step S20 is performed, that is, after a device to be charged is detected, the vehicle-mounted wireless charger is controlled to charge the device to be charged. Then, a temperature of the vehicle-mounted wireless charger is detected (step S21). After step S21 is completed, the detected temperature is compared with a preset temperature threshold (step S22). When a determining result is no, step S21 is performed again; and when the determining result is yes, the fan is controlled to operate at an initial duty cycle (step S23). After step S23 is completed, the control method proceeds to step S24, that is, a real-time vehicle speed of the vehicle is detected. Next, a theoretical duty cycle of the fan is determined based on the real-time vehicle speed and the functional relationship (step S30). Then, step S32 is performed, that is, an output power of the vehicle-mounted wireless charger is detected.

Still referring to FIG. 4, after step S32 is completed, the control method proceeds to step S33, that is, whether the output power is greater than a preset power threshold is determined. If a determining result is yes, step S31 is performed, that is, the fan is controlled to operate at the theoretical duty cycle. Next, the control method proceeds to step S40, that is, an actual duty cycle of the fan is detected. The actual duty cycle of the fan may be obtained by detecting an actual rotational speed of the fan. Then, step S41 is performed, that is, a ratio of the actual duty cycle to the theoretical duty cycle is calculated. After step S41 is completed, whether the ratio is within a preset ratio range is determined (step S42). In one or more embodiments, the preset ratio range is 90% to 110%. Alternatively, the preset ratio range may be set to another proper numerical range. When a determining result is yes, it indicates that the actual duty cycle of the fan approximates the theoretical duty cycle, and the fan operates normally. Then, step S43 is performed, that is, the fan is kept operating at the actual duty cycle. After step S43 is completed, the control method ends. When the determining result is no, it indicates that the actual duty cycle of the fan is greatly different from the theoretical duty cycle, and the fan does not operate normally (that is, the actual duty cycle is too large or too small compared with the theoretical duty cycle). Then, step S44 is performed, that is, the fan is controlled to be turned off and an alarm signal is sent. After step S44 is completed, the control method ends.

Still referring to FIG. 4, when step S33 is performed, if the determining result is no, step S34 is performed, that is, the fan is controlled to operate at an energy saving duty cycle. Next, the control method proceeds to step S45, that is, an actual duty cycle of the fan is detected. Then, step S46 is performed, that is, a ratio of the actual duty cycle to the energy saving duty cycle is calculated. After step S46 is completed, whether the ratio is within a preset ratio range is determined (step S47). When the determining result is yes, the fan is kept operating at the actual duty cycle (step S48). After step S48 is completed, the control method ends. When the determining result is no, the fan is controlled to be turned off and an alarm signal is sent. After step S49 is completed, the control method ends. It should be noted that parts not mentioned in the third embodiment may be the same as those in the first embodiment and the second embodiment, and will not be described in detail herein.
Heretofore, the technical solutions of the disclosure have been described with reference to the preferred embodiments shown in the accompanying drawings. However, those skilled in the art can readily understand that the scope of protection of the disclosure is apparently not limited to these specific embodiments. Those skilled in the art can make equivalent changes or substitutions to the related technical features without departing from the principle of the disclosure, and all the technical solutions with such changes or substitutions shall fall within the scope of protection of the disclosure.

## Claims

1. A control method for a vehicle-mounted wireless charger, wherein the vehicle-mounted wireless charger has a fan, and the control method comprises:
establishing a functional relationship between a vehicle speed of a vehicle and a duty cycle of the fan;
detecting a real-time vehicle speed of the vehicle when the vehicle-mounted wireless charger charges a device to be charged and the fan is turned on; and
determining and adjusting the duty cycle of the fan based on the real-time vehicle speed and the functional relationship, to control noise of the vehicle-mounted wireless charger.

2. The control method for a vehicle-mounted wireless charger according to claim 1, wherein the step of "determining and adjusting the duty cycle of the fan based on the real-time vehicle speed and the functional relationship" comprises:
determining a theoretical duty cycle of the fan based on the real-time vehicle speed and the functional relationship; and
controlling the fan to operate at the theoretical duty cycle.

3. The control method for a vehicle-mounted wireless charger according to claim 1 or 2, wherein the step of "determining and adjusting the duty cycle of the fan based on the real-time vehicle speed and the functional relationship" comprises:
determining a theoretical duty cycle of the fan based on the real-time vehicle speed and the functional relationship;
obtaining an output power of the vehicle-mounted wireless charger;
comparing the output power with a preset power threshold; and
when the output power is greater than the preset power threshold, controlling the fan to operate at the theoretical duty cycle.

4. The control method for a vehicle-mounted wireless charger according to claim 1, 2 or 3, wherein after the step of "determining and adjusting the duty cycle of the fan based on the real-time vehicle speed and the functional relationship", the control method further comprises: detecting an actual duty cycle of the fan;
calculating a ratio of the actual duty cycle to the theoretical duty cycle;
when the ratio is within a preset ratio range, keeping the fan operating at the actual duty cycle; and
when the ratio exceeds the preset ratio range, controlling the fan to be turned off, and sending an alarm signal.

5. The control method for a vehicle-mounted wireless charger according to any one of claims 1 to 4, wherein
determining an energy saving duty cycle of the fan when the output power is less than or equal to the preset power threshold, wherein the energy saving duty cycle is equal to the theoretical duty cycle multiplied by an energy saving coefficient, and the energy saving coefficient is greater than 0 and less than 1; and
controlling the fan to operate at the energy saving duty cycle.

6. The control method for a vehicle-mounted wireless charger according to any one of claims 1 to 5, wherein after the step of "determining and adjusting the duty cycle of the fan based on the real-time vehicle speed and the functional relationship", the control method further comprises: detecting an actual duty cycle of the fan;
calculating a ratio of the actual duty cycle to the energy saving duty cycle;
when the ratio is within a preset ratio range, keeping the fan operating at the actual duty cycle; and
when the ratio exceeds the preset ratio range, controlling the fan to be turned off, and sending an alarm signal.

7. The control method for a vehicle-mounted wireless charger according to any one of claims 1 to 6, wherein the step of "establishing a functional relationship between a vehicle speed of a vehicle and a duty cycle of the fan" comprises:
presetting a first functional relationship between the vehicle speed and the vehicle noise, a second functional relationship between the fan noise and the duty cycle of the fan, and a third functional relationship between the vehicle noise and the fan noise; and
establishing the functional relationship between the vehicle speed and the duty cycle of the fan based on the first functional relationship, the second functional relationship, and the third functional relationship.

8. The control method for a vehicle-mounted wireless charger according to claim 7, wherein the step of presetting a first functional relationship between the vehicle speed and the vehicle noise comprises:
dividing the vehicle speed into a plurality of vehicle speed intervals; and
presetting the first functional relationship between each of the vehicle speed intervals and the vehicle noise.

9. The control method for a vehicle-mounted wireless charger according to claim 8, wherein the plurality of vehicle speed intervals comprises:
a first vehicle speed interval, the first vehicle speed interval referring to a range of 30 km/h or less, and the functional relationship between the vehicle speed and the duty cycle of the fan being that the duty cycle of the fan is 42% when the vehicle speed is within the first vehicle speed interval;
a second vehicle speed interval, the second vehicle speed interval being between 30 km/h (not including 30 km/h) and 60 km/h, and the functional relationship between the vehicle speed and the duty cycle of the fan being that the duty cycle of the fan is 48% when the vehicle speed is within the second vehicle speed interval;
a third vehicle speed interval, the third vehicle speed interval being between 60 km/h (not including 60 km/h) and 80 km/h, and the functional relationship between the vehicle speed and the duty cycle of the fan being that the duty cycle of the fan is 56% when the vehicle speed is within the third vehicle speed interval; and
a fourth vehicle speed interval, the fourth vehicle speed interval referring to a range of 80 km/h or more, and the functional relationship between the vehicle speed and the duty cycle of the fan being that the duty cycle of the fan is 60% when the vehicle speed is within the fourth vehicle speed interval.

10. The control method for a vehicle-mounted wireless charger according to any one of claims 1 to 9, wherein detecting a temperature of the vehicle-mounted wireless charger after the vehicle-mounted wireless charger charges the device to be charged;
comparing the temperature with a preset temperature threshold; and
when the temperature is greater than the preset temperature threshold, controlling the fan to be turned on at an initial duty cycle.

11. A vehicle-mounted wireless charger, wherein the vehicle-mounted wireless charger uses the control method for a vehicle-mounted wireless charger according to any one of claims 1 to 10.

12. A vehicle, wherein the vehicle comprises the vehicle-mounted wireless charger according to claim 11.
